(19) Europäisches Patentamt
European Patent Office
Office européen des brevets

(11) **EP 3 829 055 B1**

(12) **EUROPEAN PATENT SPECIFICATION**

(45) Date of publication and mention of the grant of the patent:
**15.11.2023 Bulletin 2023/46**

(21) Application number: **19841000.3**

(22) Date of filing: **16.05.2019**

(51) International Patent Classification (IPC):
**H02S 50/00** (2014.01)

(52) Cooperative Patent Classification (CPC):
**H02S 50/00; G06F 30/20; Y02A 30/00; Y02E 10/50**

(86) International application number:
**PCT/KR2019/005872**

(87) International publication number:
**WO 2020/022624 (30.01.2020 Gazette 2020/05)**

(54) **METHOD FOR CALCULATING POWER GENERATION AMOUNT REFLECTING FARM ENVIRONMENT AND DETAILED TECHNOLOGY FOR PREDICTING SOLAR FARM WEATHER, AND REAL-TIME SOLAR POWER GENERATION AMOUNT PREDICTION SYSTEM USING THE METHOD**

VERFAHREN ZUR BERECHNUNG DER ENERGIEERZEUGUNGSMENGE, DAS DIE PARKUMGEBUNG REFLEKTIERT, UND DETAILLIERTE TECHNIK ZUR SOLARPARKWETTERPROGNOSE UND SYSTEM ZUR ECHTZEIT-VORHERSAGE DER SOLARENERGIEERZEUGUNGSMENGE UNTER VERWENDUNG DES VERFAHRENS

PROCÉDÉ POUR CALCULER UNE QUANTITÉ DE GÉNÉRATION D'ÉNERGIE REFLÉTANT UN ENVIRONNEMENT DE FERME ET TECHNOLOGIE DÉTAILLÉE POUR PRÉDIRE UN TEMPS MÉTÉOROLOGIQUE DE FERME SOLAIRE, ET SYSTÈME DE PRÉDICTION DE QUANTITÉ DE GÉNÉRATION D'ÉNERGIE SOLAIRE EN TEMPS RÉEL UTILISANT LE PROCÉDÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.07.2018 KR 20180087249**

(43) Date of publication of application:
**02.06.2021 Bulletin 2021/22**

(73) Proprietor: **Ecobrain Co.,Ltd.**
**Jeju-si, Jeju-do 63309 (KR)**

(72) Inventors:
• **LEE, Young Mi**
**Hanam-si Gyeonggi-do 12916 (KR)**
• **PARK, Jeong Keun**
**Seoul 05240 (KR)**
• **PARK, Da Bin**
**Seoul 05604 (KR)**

(74) Representative: **González López-Menchero, Álvaro Luis**
**Protectia Patentes y Marcas, S.L.**
**C/ Almagro, 3 2o izda.**
**28010 Madrid (ES)**

(56) References cited:
WO-A1-2017/062899    JP-A- 2018 501 582
KR-A- 20180 072 954    KR-B1- 101 035 398
KR-B1- 101 761 686    KR-B1- 101 808 047
US-A1- 2018 196 896

## Description

## Technical Field

The present invention relates to a real-time solar power generation amount prediction system and calculation method thereof and, more particularly, to a power generation amount calculation method reflecting detailed weather forecasting technology and environment of a solar power generation plant and a real-time solar power generation amount prediction system using the method thereof, wherein a statistical technique is applied to physical models for forecasting weather information, a combined physical model having the smallest error rate is set by combining a plurality of physical models, an actual insolation projected to a solar module is calculated in consideration of a position of the sun and a tracking mode of a solar power generator, and prediction of a solar power generation amount is achieved by calculating surface temperature of the solar module according to information such as temperature, wind speed, insolation, and a cooling device, so that a solar power generation amount may be more accurately predicted.

## Background Art

In general, since solar power generation uses sunlight having zero pollution and unlimited supply and having little adverse effect on the environment, solar power generation is in the spotlight as new and renewable energy generation technology. In addition, as greenhouse gas emission regulations are specifically enacted, the spread of facilities generating renewable energy including solar power is increasing, particularly in developed countries.

However, prediction of an amount of solar power generation is very difficult because the prediction is highly uncertain due to temporal and spatial variables, and the amount of solar power generation varies depending on local characteristics such as latitude and longitude, and solar elevation and atmospheric conditions over time. When the power generation amount is inaccurately predicted, the power generation plant may not be operated efficiently, and a distribution plan for the generated power may not be properly established, and thus an economic effect of solar power generation is unable to be achieved, and unbalanced power supply and demand will be resulted.

In the state of the art is known the document US2018/196896A, which discloses a device for predicting amount of photovoltaic power generation, and method for predicting amount of photovoltaic power generation.

Therefore, as in the patent document below, the power to be generated is predicted based on the new and renewable energy that has been produced previously, or the amount of solar power generation is predicted based on weather forecasting. However, since it is difficult to predict the exact weather conditions for the area where a solar power generation plant is located and the amount of solar power generation varies depending on various variables such as characteristics of the solar module as well as the weather conditions, there is a problem in that the prediction is very inaccurate.

(Patent Document)

Korean Patent No. 10-1020639 (registered on March 02, 2011) "METHOD OF PREDICTING ELECTRIC POWER AND THERMAL ENERGY FROM NEW AND RENEWABLE ENERGY SOURCES)"

## Disclosure

## Technical Problem

The present invention has been devised to solve the above problem.

An objective of the present invention is to provide a power generation amount calculation method reflecting detailed weather forecasting technology and environment of a solar power generation plant, and a real-time solar power generation amount prediction system using the method thereof, wherein forecasting of the weather information and prediction of the power generation amount are able to be achieved more accurately.

## Technical Solution

The present invention is implemented by the system and method of claims 1 and 5, further advantageous embodiments are recited in the dependent claims.

## Advantageous Effects

The present invention may obtain the following effects by a configuration, combination, and use relationship to be described below, and by the previously described exemplary embodiment.

In the present invention, a statistical technique is applied to physical models for forecasting weather information, a plurality of physical models is combined through methods using such as average and weight, so as to set a combined physical model having the smallest error rate and actual measured values, and actual measured values of the weather information are interpolated into the values of a place where a solar power generator is located, so as to be applied to calculation of an error rate, whereby there is an effect in that the forecasting of the weather information and the predicting of the power generation amount therethrough are able to be achieved more accurately.

In the present invention, an actual insolation projected to a solar module is calculated in consideration of a position of the sun and a tracking mode of a solar power generator, surface temperature of the solar module is calculated according to information such as temperature, wind speed, insolation, and cooling device, so as to predict the solar power generation amount, whereby there is an effect in that the prediction of the solar power generation amount may be achieved more accurately.

**Description of Drawings**

FIG. 1 is a configuration view of a real-time solar power generation amount prediction system according to an exemplary embodiment of the present invention.

FIG. 2 is a block diagram showing a configuration of a monitoring server of FIG. 1.

FIG. 3 is a block diagram showing a configuration of a weather forecasting part of FIG. 2.

FIG. 4 is a block diagram showing a configuration of a physical model execution part of FIG. 3.

FIG. 5 is a block diagram showing a configuration of a model statistics processing part of FIG. 3.

FIG. 6 is a reference view for explaining an execution process of the model statistics processing part.

FIG. 7 is a block diagram showing a configuration of a data interpolation part of FIG. 3.

FIG. 8 is a reference view for explaining an execution process of the data interpolation part.

FIG. 9 is a block diagram showing a configuration of a model combination part of FIG. 3.

FIG. 10 is a reference view for explaining an execution process of the model combination part.

FIG. 11 is a block diagram showing a configuration of a statistical analysis part of FIG. 3.

FIG. 12 is a block diagram showing a configuration of a power generation amount prediction part of FIG. 2.

FIG. 13 is a block diagram showing a configuration of the insolation correction part of FIG. 12.

FIG. 14 is a block diagram showing a configuration of a module temperature estimation part of FIG. 12.

FIG. 15 is a block diagram showing a configuration of a power generation amount calculation part of FIG. 12.

FIG. 16 is a flowchart showing a solar power generation amount calculation method according to the exemplary embodiment of the present invention.

FIG. 17 is a comparison graph of solar power generation amounts predicted according to the solar power generation amount calculation method according to the exemplary embodiment of the present invention.

<Description of the main numerals in the drawings>

1: solar power generator 11: solar module

3: monitoring server

31: weather forecasting part 311: weather observation receiving part 312: physical model execution part

312a: initial field receiving module 312b: physical model execution module 312c: model optimization module

313: model statistics processing part 313a: grid point selection module 313b: grouping module by preceding time

313c: correlation coefficient analysis module 313d: regression analysis execution module 314: data interpolation part

314a: case classification module 314b: function calculation module 314c: weight calculation module

314d: interpolation value calculation module 315: model combination part 315a: optional execution module

315b: average execution module 315c: weight execution module 315d: error analysis verification module

316: statistical analysis part 316a: statistical analysis execution module 316b: error verification module

33: power generation amount prediction part 331: solar position tracking part 332: insolation correction part

332a: predicted insolation receiving module 332b: solar position information receiving module

332c: solar tracking mode receiving module 332d: insolation calculation module

333: module temperature estimation part 333a: wind speed information receiving module 333b: temperature information receiving module

333c: insolation information receiving module 333d: cooling device information receiving module

333e: module temperature information receiving module 333f: correlation analysis module

333g: module surface temperature calculation module 334: power generation amount calculation part

334a: rated output receiving module 334b: corrected insolation receiving module

334c: module temperature receiving module 334d: output temperature coefficient receiving module

334e: loss coefficient calculation module 334f: power generation amount calculation module 35: data storage

5: display

**Best Mode**

Hereinafter, with reference to the accompanying drawings, preferred exemplary embodiments of a power generation amount calculation method reflecting detailed weather forecasting technology and environment of a solar power generation plant and a real-time solar power generation amount prediction system using the method thereof according to the present invention will be described in detail. In the following description of the present invention, it is to be noted that, when a detailed description of a known function or configuration may unnecessarily obscure the subject matter of the present invention, the detailed description thereof will be omitted. Throughout the specification, when a part "includes" or "comprises" a certain component, it means that other components may be further included rather than excluding other components unless otherwise indicated. In addition, terms such as "... part" and "... module" described in the specification mean a part that processes at least one function or operation, which may be implemented in hardware or software, or a combination of hardware and software.

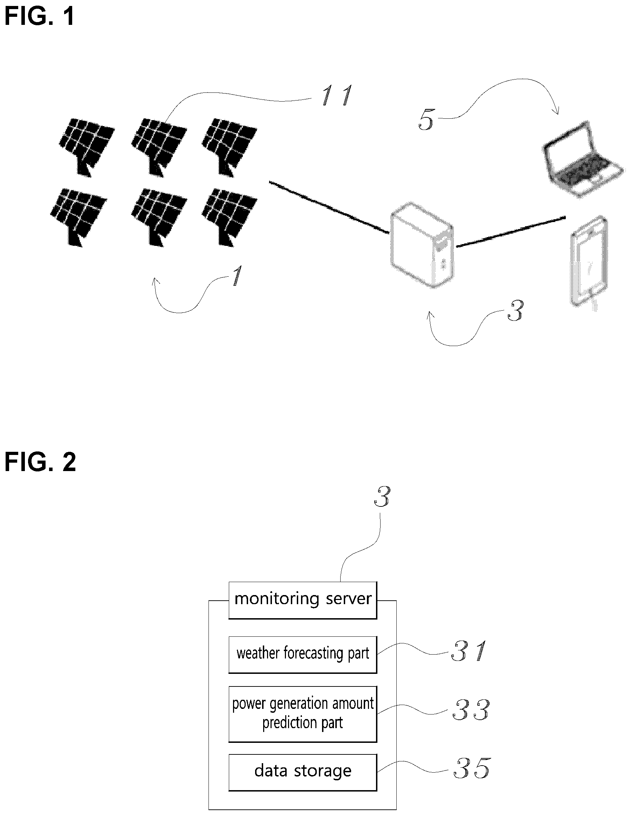

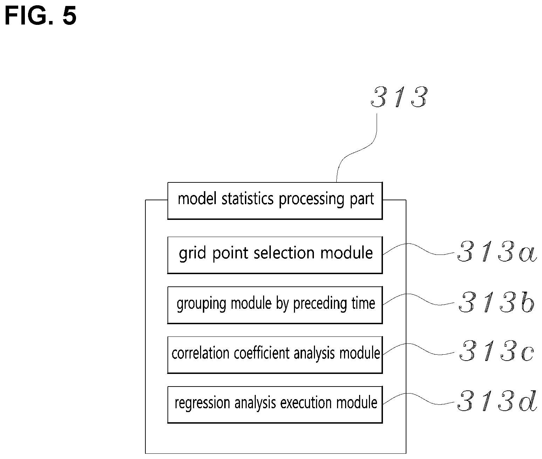

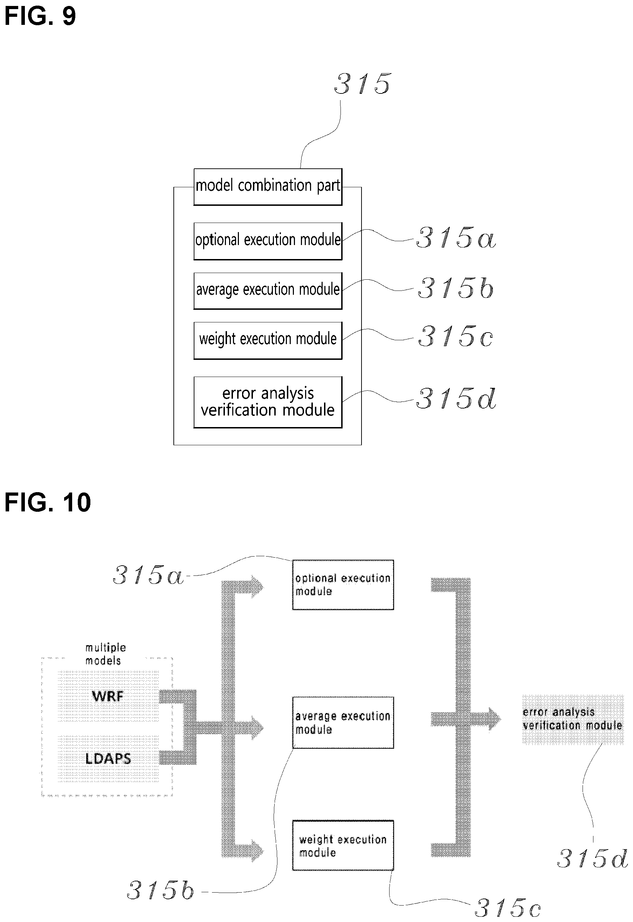

Referring to FIGS. 1 to 15, in a real-time solar power generation amount prediction system reflecting detailed weather forecasting technology and environment of a solar power generation plant according to an exemplary embodiment of the present invention, the solar power generation amount prediction system includes: a solar power generator 1 installed at a certain place and generating power by sunlight; a monitoring server 3 that predicts weather at a place where the solar power generator 1 is installed, and predicts a power generation amount of the solar power generator 1 by using predicted weather information and information of the solar power generator 1; and a display 5 for displaying the weather information and the power generation amount predicted by the monitoring server 3.

In particular, in the solar power generation amount prediction system according to the present invention, a power generation amount of the solar power generator 1 is predicted by using weather forecasting, statistical methods are applied to physical models in order to increase accuracy of the weather forecasting, weather data measured by using spatial distribution characteristics is interpolated based on the place where the solar power generator 1 is located, and the optimal values of the weather forecasting may be derived by using a plurality of physical models. In addition, in the solar power generation amount prediction system, an insolation incident on a solar module 11 may be accurately calculated by using position information of the sun and tracking mode information of the solar power generator 1, and the solar power generation amount is calculated by estimating temperature of the solar module 11, so that prediction accuracy of solar power generation amount may be further improved.

The solar power generator 1 is a component installed at a certain place to generate power by sunlight. The solar power generator 1 may be configured such that a plurality of solar modules 11 are gathered to form a single power generation plant, and comprehensively includes the solar modules 11 installed in homes, buildings, etc. The power generated by the solar power generator 1 may be saved in a certain storage device and supplied afterward, or may be a subject of electricity trading, and the power generation amount may be accurately predicted by the present system so as to allow supply, distribution, and sales plans to be established.

The monitoring server 3 is a component predicting the weather at the place where the solar power generator 1 is located. The monitoring server 3 predicts power generation amount of the solar power generator 1 by using the predicted weather information, and may allow the predicted weather information to be displayed through a display 5. The monitoring server 3 may include: a weather forecasting part 31 for predicting weather at the place where the solar power generator 1 is located; a power generation amount prediction part 33 for predicting a power generation amount of the solar power generator 1; and a data storage 35 for storing weather information, information on the solar power generator 1, etc., which are required for prediction.

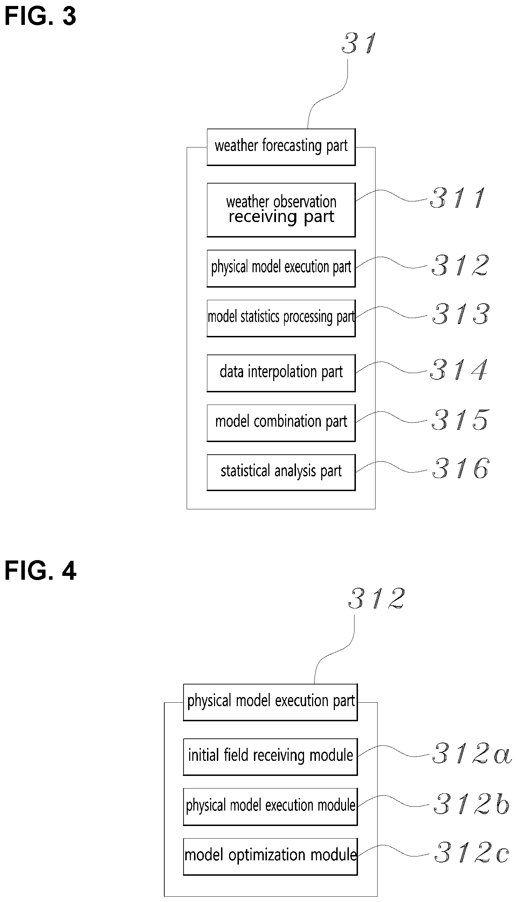

The weather forecasting part 31 is a component predicting the weather at the place where the solar power generator 1 is located. The weather forecasting part 31 executes physical models for weather prediction so as to predict weather forecasting information at a certain time interval for a certain place, may modify the physical models through comparison with an actual measured weather information for a certain period of time, may generate a combined physical model having the highest accuracy by combining the plurality of physical models, and when evaluating accuracy of the physical models, and uses data interpolated with the weather information of the place where the actual solar power generator 1 is located, thereby maximizing the forecasting accuracy of the weather information. In addition, the weather forecasting part 31 may also increase the accuracy by analyzing weather data predicted for a certain period of time through various statistical methods. To this end, as shown in FIG. 3, the weather forecasting part 31 may include: a weather observation receiving part 311; a physical model execution part 312; a model statistics processing part 313; a data interpolation part 314; a model combination part 315; and a statistical analysis part 316.

The weather observation receiving part 311 is a component receiving weather information measured in real time. The weather observation receiving part 311 receives the weather information of each place where the solar power generator 1 is located, and for example, may receive information such as temperature, humidity, wind speed, and insolation, which are provided by the Korea Meteorological Administration. The weather observation receiving part 311 may receive weather information every hour, and may allow the received weather information to be stored by the data storage 35, so as to be used as basic data for forecasting weather and predicting a power generation amount.

The physical model execution part 312 is a component predicting weather changes in a certain area, especially the area where the solar power generator 1 is located. The physical model execution part 312 executes physical models related to weather forecasting by using initial field information provided at a predetermined time interval, and optimizes the physical models by changing physical options through comparison with each measured value. To this end, the physical model execution part 312 may include: an initial field receiving module 312a; a physical model execution module 312b; and a model optimization module 312c.

The initial field receiving module 312a is a component receiving initial prediction data for execution of each physical model. The initial field receiving module 312a may preferably be provided with GFS (Global Forecast System) data provided by National Centers for Environmental Prediction (NCEP), wherein the initial field information included in the GFS data may have a resolution of 1 degree of latitude and longitude grid intervals at six hour intervals. Naturally, the initial field receiving module 312a may also receive the initial field information through another channel. In the present exemplary embodiment, the GFS data provided at six hour intervals is received at six hour intervals so that the physical models may be performed, and the received initial field information may be stored by the data storage 35.

The physical model execution module 312b is a component predicting changes in weather in the area where the solar power generator 1 is located. The physical model execution module 312b predicts the changes in the weather by using the weather information received by the initial field receiving module 312a and the weather information received by weather observation receiving part 311. For example, the initial field information at six hour intervals and weather observation data at one hour intervals may allow increasing the accuracy of weather forecasting through a process of data assimilation, and when executing each physical model, it is possible to use a terrain elevation, land cover data at 100 meter intervals, etc., within an area for prediction. It is preferable that the physical model execution module 312b extracts weather forecasting data at 1 km intervals and one hour intervals until the next 30 hours, but is not necessarily limited thereto, and for example, the weather forecasting data may be extracted by using physical models of WRF (Weather Research and Forecasting) and UM-LDAPS (Unified Model-Local Data Assimilation and Prediction System).

The model optimization module 312c is a component increasing the accuracy of the physical models by applying various physical options to the physical models executed by the physical model execution module 312b. The model optimization module 312c optimizes the physical models through comparison with the weather observation values actually measured over a period of time. Therefore, the model optimization module 312c changes physical equations, options, etc., in physical models, to make a comparison with the observed values actually measured, and optimizes the physical models by applying the physical equations and options having the least error from the actual measured values.

The model statistics processing part 313 is a component increasing prediction accuracy of physical models by applying a statistical technique to the physical models executed by the physical model execution part 312. For example, the model statistics processing part 313 may be applied to each of the WRF physical model and UM-LDAPS physical model. The model statistics processing part 313 may correct values calculated by physical models through statistical analysis by comparing the weather data predicted for a certain period of time with the actual measured weather observation values. In particular, the model statistics processing part 313 selects a grid point closest to a place P where a solar power generator 1 is located, increases accuracy of statistical analysis by grouping predicted data for each preceding time for the selected grid point, analyzes a correlation coefficient by comparing the grouped data with the actual measured values, and calculates a linear regression equation therethrough, so as to be applied to the physical models. To this end, the model statistics processing part 313 may include: a grid point selection module 313a; a grouping module 313b by preceding time; a correlation coefficient analysis module 313c; and a regression analysis execution module 313d.

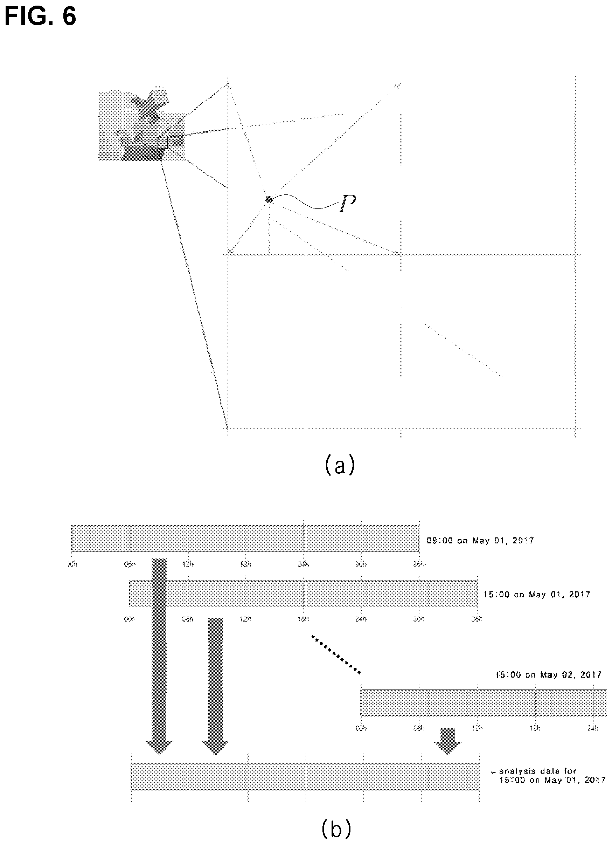

As shown in FIG. 6(a), the grid point selection module 313a is a component selecting a grid point corresponding to the place P where the solar power generator 1 is located. The grid point selection module 313a selects a grid point based on the grid where weather forecasting data is generated, so that a comparison of the grouped data for each preceding time and the actual measured values are performed.

The grouping module 313b by preceding time is a component grouping weather forecasting data for each preceding time with respect to a selected grid point. The grouping module 313b groups predicted data for each time period by combining information of each preceding time period, the information generating weather forecasting information. For example, as shown in FIG. 6(b), in the grouping module 313b by preceding time, the weather data predicted at 15:00 on May 1, 2017 (e.g., preceding time) is grouped by combining predicted information of the preceding and following times, the predicted information having predicted information of the same time period, and the grouped information may be compared with the actual observed values. In other words, the forecast information after 24 to 30 hours from 15:00 on May 1, 2017 allows the weather forecast data to be grouped by combining: forecast information after 30 to 36 hours from 9:00 on May 1, 2017; forecast information after 18 to 24 hours from 21:00 on May 1, 2017; and predicted information for 0 to 6 hours at 15:00 on May 2, 2017 at six hour intervals, and compares the corresponding data with the actual measured values.

The correlation coefficient analysis module 313c is a component analyzing a correlation coefficient between the actual measured weather observation values of the corresponding grid point and the grouped prediction data for the corresponding time period. The correlation coefficient analysis module 313c may allow a linear regression equation to be derived by analyzing the correlation therebetween.

The regression analysis execution module 313d is a component correcting weather forecasting values calculated by the physical models by using the linear regression equation derived by the correlation coefficient analysis module 313c. The regression analysis execution module 313d may correct the weather forecasting values by applying the linear regression equation to the weather forecasting values calculated by each of the WRF model and UM-LDAPS model, for example.

The data interpolation part 314 is a component interpolating the weather observation information received from the weather observation receiving part 311 into information of the place where the solar power generator 1 is located by applying a spatial distribution correction technique. The data interpolation part 314 may extract the data of an accurate place where the solar power generator 1 is located through a linear combination of data of various places where weather information is observed, and for example, may use a technique of kriging. When weather observation data is interpolated by the data interpolation part 314, the model combination part 315 uses the weather observation data during execution, so that a more accurate comparison with the observed values may be performed. To this end, the data interpolation part 314 may include: a case classification module 314a; a function calculation module 314b; a weight calculation module 314c; and an interpolation value calculation module 314d.

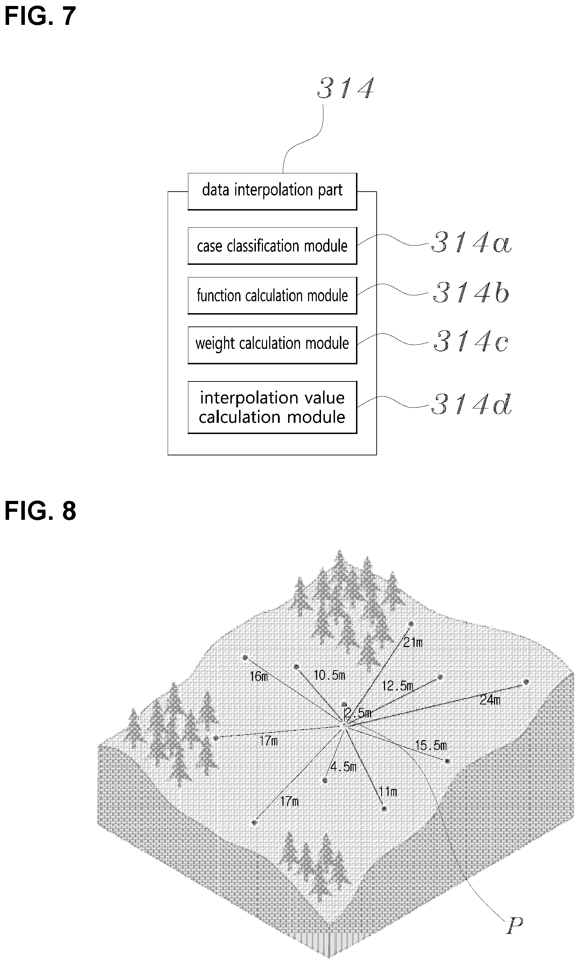

The case classification module 314a is a component classifying cases, according to a distance to each place used for data interpolation, based on the position P of the solar power generator 1. For example, as shown in FIG. 8, the case classification module 314a may classify the cases at intervals of 5 meter. Accordingly, the case classification module 314a may extract the weather information of the place where the solar power generator 1 is located by determining a linear relationship between weather information of each case classified by the case classification module 314a.

The function calculation module 314b is a component calculating a function through a linear relationship according to a distance of each place, may use Variogram. The function calculation module 314b expresses the function as a distance dependent function by analyzing a correlation according to variance between each of the observed values.

The weight calculation module 314c is a component calculating a weight for each place. The weight calculation module 314c calculates the weight by reflecting not only the distance to each place but also correlational strength between each measured value. Accordingly, the weight calculation module 314c calculates the weight for each place through statistical analysis, and by reflecting the weight, may generate interpolated data for the place where the solar power generator 1 is located.

The interpolation value calculation module 314d is a component generating weather observation data at the place where the solar power generator 1 is located by using the function calculated by the function calculation module 314b and the weight calculated by the weight calculation module 314c. The interpolation value calculation module 314d calculates interpolation values by applying the calculated function and weight to values of the surrounding places, and may allow the interpolation values to be calculated in the form of [Equation 1] below.

[Equation 1]

$$\hat{Z}(s_0) = \sum_{i=1}^{N} \lambda_i Z(s_i)$$

(where, si: values of surrounding places, λi: weight of surrounding places, s0: places to be interpolated, N: number of surrounding places)

The model combination part 315 is a component increasing prediction accuracy by combining a plurality of physical models executed by the physical model execution part 312. The model combination part 315 may combine the WRF model and the UM-LDAPS model as an example, and may generate a combination by using various physical models without being limited thereto. The model combination part 315 may derive predicted values by selectively using each physical model, or by using average of the values calculated by each physical model, or by varying a weight for each model having high accuracy or a weight for each preceding time, and selects a model having a less error by comparing the values derived in this way with the actual measured values, thereby helping to increase the prediction accuracy. Therefore, the model combination part 315 sets a prediction model having the least error for each solar power generator 1, so that the weather at a place where each solar power generator 1 is located may be accurately forecasted, and the model combination part 315 uses the data interpolated by the data interpolation part 314 when comparing with the actual measured values, so that the accuracy is further increased. To this end, the model combination part 315 may include: an optional execution module 315a; an average execution module 315b: a weight execution module 315c: and an error analysis verification module 315d.

The optional execution module 315a is a component selectively executing the plurality of physical models. The optional execution module 315a compares the executed results of the physical models with each other by the error analysis verification module 315d, and selects physical models having the least error rate, so as to be used for prediction.

The average execution module 315b is a component that calculates an average of the results predicted by the plurality of physical models, wherein the error analysis verification module 315d compares the calculated average with the values calculated by the optional execution module 315a and the weight execution module 315c.

The weight execution module 315c is a component executing each physical model by assigning a weight, and for example. The weight execution module 315c may assign the weight to a model having high accuracy, or assign the weight for each preceding time. Accordingly, the weight execution module 315c may execute the physical models by assigning the weight to the physical models having high accuracy on the basis of past prediction information for a specific solar power generator 1, and may execute physical models by assigning a different weight, depending on the preceding time, to the physical models. The models executed in this way are verified again for their accuracy by the error analysis verification module 315d, so that the most accurate method may be applied.

The error analysis verification module 315d is a component calculating an error rate by comparing the actual measured values with the predicted values, which are respectively derived by the optional execution module 315a, the average execution module 315b, and the weight execution module 315c. The error analysis verification module 315d may use methods such as Bias, RMSE, MAE, nMAE, IOA, and R. Referring to an equation of IOA (Index of Agreement) which is one of the methods, an IOA equation is as shown in [Equation 2] below.

[Equation 2]

$$IOA = 1 - \frac{\sum_{i=1}^{n}(M_i - O_i)^2}{\sum_{i=1}^{n}(|M_i - \overline{O}| + |O_i - \overline{O}|)^2}$$

(where, M: model value, O: observed value, n: number of data)

Accordingly, the error analysis verification module 315d calculates and compares each error rate, and calculates values derived by the models having the least error rate to be weather forecasting values. At this time, as described above, the error analysis verification module 315d uses the values interpolated by the data interpolation part 314 as actual measured values, and selects and sets a prediction model for each solar power generator 1, so as to be able to increase accuracy of weather forecasting for the solar power generator 1 and accuracy of prediction for power generation amount, accordingly.

The statistical analysis part 316 is a component further increases the prediction accuracy by additionally performing statistical analysis for a certain period of time on the weather forecasting values of the area where the solar power generator 1 is located, and although it may be sufficient to derive predicted values by the model combination part 315, when the predicted values for a certain period of time is accumulated, the statistical analysis of the predicted values is performed. The statistical analysis part 316 may find statistical rules or patterns in accumulated data by using statistical analysis methods, such as decision tree, conditional reasoning tree, and random forest, through execution of the statistical analysis module 316a, may verify an error rate by comparing the actual measured values with the values derived by the error verification module 316b, and may calculate the weather prediction values by the statistical analysis method having the smallest error rate. Since a description of the error verification module 316b is the same as the description of the error analysis verification module 315d, the description will be omitted below.

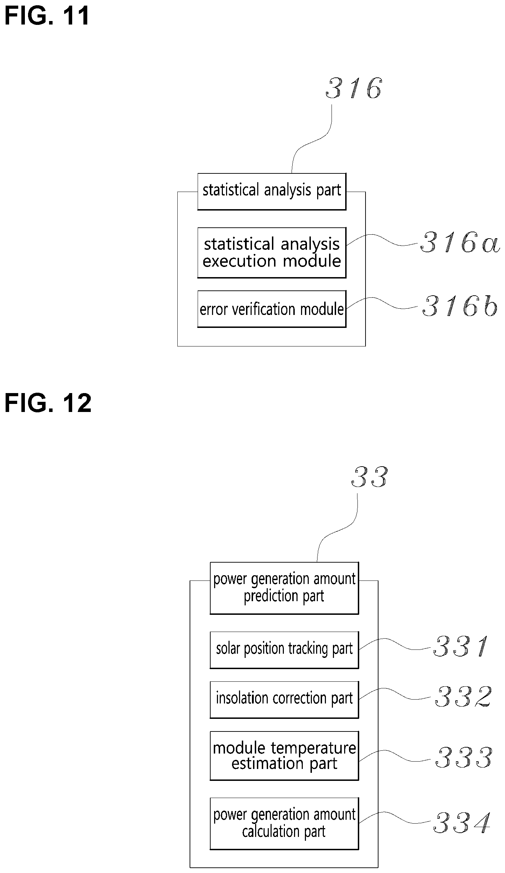

The power generation amount prediction part 33 is a component predicting solar power generation amount of the solar power generator 1 by using weather information predicted by the weather forecasting part 31 and device information for the solar power generator 1. The power generation amount prediction part 33 predicts the solar power generation amount by using information such as the insolation incident on the solar module 11 of the solar power generator 1, the surface temperature of the solar module 11 accordingly, an output temperature coefficient, a loss factor. At this time, insolation is obtained based on the insolation predicted by the weather forecasting part 31, and the insolation is corrected in consideration of an angle between the sun and the solar module 11, so that it is possible to accurately calculate the insolation incident on the solar module 11. In addition, surface temperature of the solar module 11 is calculated by using information such as wind speed, temperature, and insolation, which are predicted by the weather forecasting part 31, and by using cooling device information of the solar power generator 1. As shown in FIG. 12, the power generation amount prediction part 33 may include: a solar position tracking part 331; the insolation correction part 332; a module temperature estimation part 333, and a power generation amount calculation part 334.

The solar position tracking part 331 is a component tracking a position of the sun in order to correct the insolation. The solar position tracking part 331 calculates the elevation angle and azimuth angle of the sun by time. The solar position tracking part 331 may use various algorithms for calculating the position of the sun, and may use various algorithms that simplifies or approximates astronomical relations in a form applicable to the solar power generation amount prediction system, the astronomical relations interpreting a position change according to the Earth's rotation and revolution and the short-period micro-irregular motion of the Earth occurring in the position change process accordingly. The solar position tracking part 331 may selectively use various algorithms such as Walrevan, Michalsky, and Grena algorithms.

The insolation correction part 332 corrects insolation information predicted by the weather forecasting part 31 in consideration of the angle between the sun and the solar module 11. The insolation information predicted by the weather forecasting part 31 predicts the insolation incident on a specific area, and since the angle formed by the sun and the solar module 11 is not considered, the insolation may be corrected in consideration of the angle made by the sun and the solar module 11. At this time, when the solar module 11 is formed in a fixed type, the solar module 11 is usually installed at an inclination of 30 degrees, and may be able to be formed in a tracking type in which the inclination is changed according to the position of the sun. In addition, even in the case of the tracking type, the solar module 11 may be provided in various ways such as a single axis tracking mode, an azimuth tracking mode, and a double axis tracking mode. Accordingly, the insolation correction part 332 tracks the position of the sun and corrects the insolation according to the tracking type of the solar module 11, so that the insolation may be accurately corrected according to the inclination of the solar module 11. To this end, the insolation correction part 332 may include: a predicted insolation receiving module 332a; a solar position information receiving module 332b; a solar tracking mode receiving module 332c; and the insolation calculating module 332d.

The predicted insolation receiving module 332a is a component receiving insolation information predicted by the weather forecasting part 31. The predicted insolation receiving module 332a may receive the insolation information at a predetermined time interval, wherein the insolation information is accurately corrected by values of insolation, incident on the solar module 11, according to the position of the sun and the tracking mode of the solar module 11.

The solar position information receiving module 332b is a component receiving the solar position information predicted by the solar position tracking part 331. The solar position information receiving module 332b receives the information of elevation angle and azimuth angle of the sun depending on time.

The solar tracking mode receiving module 332c is a component receiving information on the tracking mode of the solar power generator 1 to predict the power generation amount. The solar tracking mode receiving module 332c receives detailed information about the angle of movement depending on the position of the sun, the detailed information including whether the tracking mode is the fixed type, or the single axis tracking mode, or the like. The information about each solar power generator 1 is stored by the data storage 35, and the solar tracking mode receiving module 332c receives information of the solar power generator 1 to predict the power generation amount from the data storage 35.

The insolation calculating module 332d is a component correcting the insolation information received by the predicted insolation receiving module 332a in consideration of the inclination of the solar module 11. The insolation calculating module 332d corrects the insolation according to the inclination formed by the sun and the solar module 11 depending on the elevation and azimuth angle of the sun, and in particular, may allow the insolation to be calculated by way of changing the angle, formed between the sun and the solar module 11, according to the tracking mode of the solar module 11.

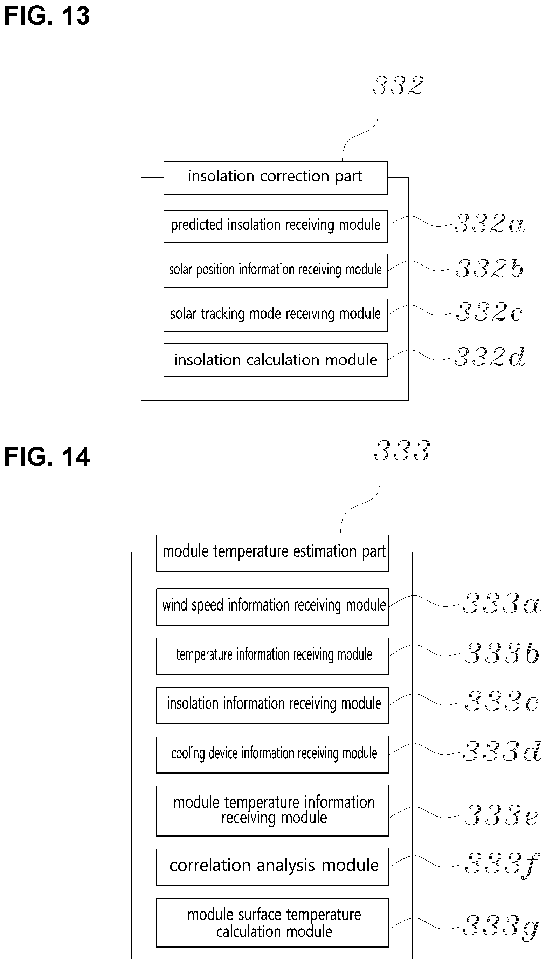

The module temperature estimation part 333 is a component estimating and predicting the temperature of the solar module 11. The module temperature estimation part 333 uses information on wind speed, temperature, and insolation which are predicted by the weather forecasting part 31, and information on the cooling device of the solar power generator 1, so as to analyze a correlation with regard to the actual measured surface temperature of the solar module 11, and may calculate the module surface temperature according to the analyzed correlation. In other words, the module temperature estimation part 333 uses the weather information accumulated for a certain period of time and the information of the solar power generator 1, so as to analyze the correlation with the surface temperature of the solar module 11, and according to the analyzed correlation, may predict the module surface temperature at a certain point in time in the future by way of using weather information to be predicted in the future and information of the solar power generator 1. In general, when temperature of the solar module 11 rises from 25 degrees Celsius to 1 degree Celsius, power generation efficiency decreases depending on the output temperature coefficient of the solar module 11. Therefore, the module surface temperature is predicted so that the power generation amount is predicted accordingly, whereby it is possible to increase the prediction accuracy of power generation amount. As shown in FIG. 14, the module temperature estimation part 333 may include: a wind speed information receiving module 333a; a temperature information receiving module 333b; the insolation information receiving module 333c; a cooling device information receiving module 333d; a module temperature information receiving module 333e; a correlation analysis module 333f; and a module surface temperature calculation module 333g.

The wind speed information receiving module 333a, temperature information receiving module 333b, and insolation information receiving module 333c are modules that receive information of wind speed, temperature, and insolation which are predicted by the weather forecasting part 31, receive the predicted information in real time, and continually store the predicted information. Accordingly, the correlation may be analyzed through comparison with the surface temperature of the solar module 11 measured for a certain period of time, and the surface temperature of the solar module 11 may be calculated according to the correlation analyzed using the predicted wind speed, temperature, and insolation information after a certain point in time.

The cooling device information receiving module 333d is a component receiving information on a cooling device of a solar power generator 1. The cooling device information receiving module 333d receives information about the cooling device of each solar power generator 1, the information being stored by the data storage 35.

The cooling device for cooling the solar module 11 is installed in the solar power generator 1, wherein the surface temperature of the solar module 11 naturally shows different values depending on the presence of the cooling device and the performance of the cooling device. Accordingly, the cooling device information receiving module 333d receives information on the presence or absence of the cooling device and information on performance of the cooling device, and by classifying the performance of the cooling device on a predetermined basis, the correlation with the surface temperature of the solar module 11 according to the performance may be analyzed together.

The module temperature information receiving module 333e is composed of a component measuring and receiving surface temperature of the solar module 11. The module temperature information receiving module 333e may measure the surface temperature through a separate temperature measuring means provided in the solar module 11, and analyzes a correlation by comparing the surface temperature information measured for a certain period of time with the information on wind speed, temperature, insolation, and cooling device performance.

The correlation analysis module 333f is a component analyzing a correlation between the surface temperature of the solar module 11 and the information on wind speed, temperature, insolation, and the cooling device of the solar power generator 1. The correlation analysis module 333f analyzes the correlation by comparing the information received over a period of time with the measured surface temperature. When the correlation between the information on wind speed, temperature, and insolation, and the information on the cooling device is analyzed by the correlation analysis module 333f, the analyzed correlation is allowed to be used, by the module surface temperature calculation module 333g, in predicting the module surface temperature at a certain point in time.

The module surface temperature calculation module 333g is a component calculating the surface temperature of the solar module 11 by using the correlation analyzed in the correlation analysis module 333f. The module surface temperature calculation module 333g calculates the surface temperature of the solar module 11 at a certain point in time in the future by applying the correlation to the information, on wind speed, temperature, and insolation, which are predicted by the weather forecasting part 31, and the information, on the cooling device, which is stored by the data storage 35.

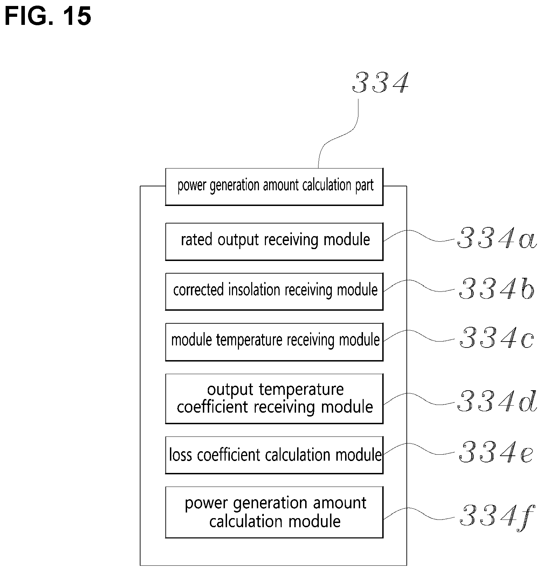

The power generation amount calculation part 334 is a component predicting a power generation amount by the solar power generator 1 by using the weather information predicted by the weather forecasting part 31 and by using the device information of the solar power generator 1. The power generation amount calculation part 334 calculates the amount of solar power generation in consideration of the insolation corrected by the insolation correction part 332 and the surface temperature of the solar module 11 estimated by the module temperature estimation part 333, together with the output temperature coefficient and the loss coefficient. The power generation amount generated by the solar module 11 is proportional to the insolation, and decreases in proportion to the output temperature coefficient each time the surface temperature of the solar module 11 increases by 1 degree Celsius from 25 degrees Celsius. As shown in FIG. 15, the power generation amount calculation part 334 may include: a rated output receiving module 334a; a corrected insolation receiving module 334b; a module temperature receiving module 334c; an output temperature coefficient receiving module 334d; a loss coefficient calculation module 334e; and a power generation amount calculation module 334f.

The rated output receiving module 334a receives information on a rated output, which is set for each solar power generator 1, from the data storage 35, so that the power generation amount may be predicted, in which the insolation, the module temperature, etc., have been reflected on the basis of the rated output. For example, the rated output may mean an output at a temperature of 25 degrees Celsius and a solar radiation intensity of 1 kw/m2, and is set to each unique value for each solar power generator 1.

The corrected insolation receiving module 334b receives the corrected insolation information calculated from the insolation correction part 332.

The module temperature receiving module 334c receives information on the surface temperature of the solar module 11 calculated from the module temperature estimation part 333.

The output temperature coefficient receiving module 334d is a component receiving information on the output temperature coefficient set for each solar power generator 1. As described above, the power generation amount decreases in proportion to the output temperature coefficient every time the surface temperature increases by 1 degree Celsius from 25 degrees Celsius.

The loss coefficient calculation module 334e is a component calculating the loss coefficient of each solar power generator 1. A loss coefficient represents a ratio of an actual measured power generation amount to a predicted power generation amount. Accordingly, the loss coefficient calculation module 334e calculates the ratio of the actual measured power generation amount to the predicted power generation amount, before a certain period from a point in time when prediction for a specific solar power generator 1 is executed, and reflects the ratio when predicting a future generation amount.

The power generation amount calculation module 334f may calculate a power generation amount predicted at a certain point in time by using information such as a rated output of each solar power generator 1, a predicted and corrected insolation, surface temperature of solar module 11, an output temperature coefficient, a loss coefficient, etc. For example, [Equation 3] may be used to calculate the power generation amount.

[Equation 3]

$$Pm(t) = Pm \times Q \times [1 + \alpha(t - 25)] \times c$$

(where, Pm(t): maximum output under operating conditions, Pm: rated output (25 degrees Celsius, solar radiation intensity is 1 kw/m2),

Q: corrected insolation (kw/m2), t: module surface temperature, $\alpha$: output temperature coefficient, c: loss coefficient)

The data storage 35 is a component storing information for forecasting weather and predicting power generation amount in the monitoring server 3. The data storage 35 may store information such as weather observation information received from the weather observation receiving part 311, weather forecasting information predicted by the weather forecasting part 31, a rated output of each solar power generator 1, an output temperature coefficient, place information of the solar power generator 1, tracking mode information, cooling device information, the number of modules.

The display 5 is a component displaying weather information, power generation amount information, etc., which are predicted by the monitoring server 3. Various devices such as computers and mobile terminals may be applied as the display 5.

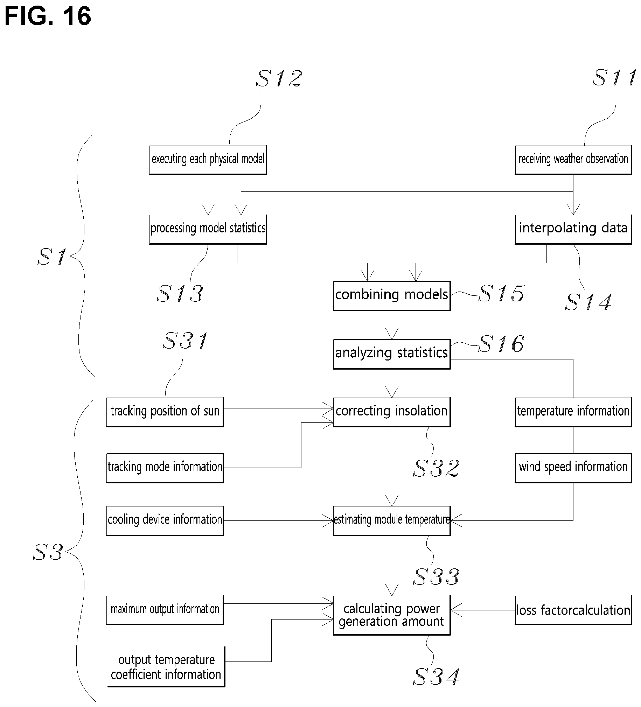

Referring to FIG. 16, and describing a power generation amount calculation method reflecting detailed weather forecasting technology and environment of a solar power generation plant according to the exemplary embodiment of the present invention, the power generation amount calculation method includes: step S1 of forecasting weather, wherein weather is forecasted at a place where a solar power generator is located; and step S3 of predicting power generation amount, wherein a solar power generation amount is predicted at a specific time on the basis of weather information predicted in the step S1 of forecasting weather.

The step S1 of forecasting weather may include: step S11 of receiving weather observation; step S12 of executing each physical model; step S13 of processing model statistics; step S14 of interpolating data; step S15 of combining models; and step S16 of analyzing statistics.

In the step S11 of receiving weather observation, weather observation information is received, from the Korea Meteorological Administration, etc., by a weather observation receiving part 311, and in the step S12 of executing each physical model, initial field information is received by a physical model execution part 312, each physical model generating weather forecasting information for an area where a solar power generator 1 is located is executed, and each physical model is optimized so that the optimal physical options and equations are applied through comparison with an actual measured values.

In addition, in the step S13 of processing model statistics, prediction accuracy is increased by applying a statistical analysis method to the executed physical models, and a model statistics processing part 313 is allowed to be executed. Accordingly, in the step S13 of processing model statistics, a grid point at the place where the solar power generator 1 is located is selected, so as to group predicted data by preceding time for the selected grid point, the grouped data is compared with the actual measured weather observation values, so as to analyze a correlation coefficient, and a linear regression equation is calculated based on the analyzed correlation coefficient, so as to be applied to each physical model.

In addition, the weather observation values received in the step S11 of receiving weather observation are interpolated to the values at the place where the solar power generator 1 is actually located in the step S14 of interpolating data, and may be applied with a spatial distribution correction technique, such as kriging, by a data interpolation part 314. Therefore, in the step S14 of interpolating data, cases are classified according to a separation distance from the place where the solar power generator 1 is located, a linear relationship for each case is determined, so as to calculate a function, correlation strength between each of the measured values is reflected, so as to calculate a weight, and accordingly, each interpolation value of the place where the solar power generator 1 is located is calculated.

In addition, in the step S15 of combining models, a combined physical model having the smallest error rate may be selected by combining a plurality of physical models executed in the step S12 of executing each physical model, and at this time, the plurality of physical models uses the physical models on which regression analysis has been performed in the step S13 of processing model statistics. In the step S15 of combining models, by a model combination part 315, the plurality of physical models are selectively used, or each average value is used or a weight is assigned to be used, and the combination of the physical models having the least error rate is selected, so that weather forecasting values may be calculated by the combined physical model.

In the step S16 of analyzing statistics, the predicted values that are processed in the step S12 of executing each physical model, step S13 of processing model statistics, step S14 of interpolating data, and step S15 of combining models are accumulated and stored for a certain period of time. The step S16 of analyzing statistics is the process of performing statistical analysis of the corresponding predicted values, wherein a statistical analysis part may find statistical rules or patterns by using statistical analysis methods such as decision tree, conditional reasoning tree, random forest, logistic regression, and support vector machine.

The step S3 of predicting power generation amount is a process of predicting the power generation amount by using the weather information, predicted in the step S1 of forecasting weather, and the device information of the solar power generator 1, and may include: step S31 of tracking a position of the sun; step S32 of correcting an insolation; step S33 of estimating module temperature; and step S34 of calculating power generation amount.

The step S31 of tracking a position of the sun is the process of tracking the position of the sun over time, wherein a solar position tracking part 331 is executed, and the elevation and azimuth of the sun over time are calculated through various algorithms for tracking the position of the sun.

The step S32 of correcting an insolation is the process of correcting the insolation information, predicted in the step S1 of forecasting weather, to the insolation in consideration of the angle of the solar module 11 with respect to the sun, and the insolation correction part 332 is executed. Therefore, in the step S32 of correcting an insolation, the predicted insolation information, the position information of the sun, and information on the tracking mode of the solar power generator 1 are received, and the predicted insolation may be corrected by calculating the angle between the sun and the solar module 11 according to the position of the sun and the rotation of the solar power generator 1 depending on the position of the sun.

The step S33 of estimating module temperature is the process of predicting the surface temperature of the solar module 11 for predicting the power generation amount, and a module temperature estimation part 333 is executed. Therefore, in the step S33 of estimating module temperature, wind speed and temperature information predicted in the step S1 of forecasting weather and the insolation information corrected in the step S32 of correcting an insolation are received, information about the cooling device of the solar power generator 1 is received so as to analyze correlation through comparison with the actual measured surface temperature of the solar module 11, and the surface temperature of the solar module 11 may be predicted according to the analyzed correlation.

The step S34 of calculating power generation amount is the process of predicting the power generation amount of the solar power generator 1 by using the corrected insolation information, surface temperature information of the solar module 11, output temperature coefficient, and loss coefficient, and the power generation amount calculation part 334 is executed. Therefore, in the step S34 of calculating power generation amount, the rated output of each solar power generator 1 is multiplied by the corrected insolation, the power generation amount is decreased in proportion to the output temperature coefficient as the module surface temperature rises at 25 degrees Celsius, and the power generation amount is decreased in proportion to the calculated loss factor (i.e., predicted power generation amount = power generation amount - (power generation amount * loss factor).

The solar power generation amount calculation method using weather forecasting according to the present invention will be described in more detail. However, the method is only for describing the present invention in more detail, and the scope of the present invention is not limited thereto.

< Exemplary Embodiment >

1. Weather forecasting information applied with the step S13 of processing model statistics, step S14 of interpolating data, and step S15 of combining models is generated by using the WRF physical model and the UM-LDAPS physical model from May 17, 2017 to November 28, 2017, and the power generation amount is predicted through the weather forecasting information.

2. The step S31 of tracking a position of the sun, step S32 of correcting an insolation, and step S33 of es-

timing module temperature are additionally applied to exemplary embodiment 1, so that the power generation amount is predicted.

< Comparative Embodiment >

The weather forecasting data in which only the WRF physical model is executed, the predicted insolation, and the temperature information are used, so as to predict the power generation amount.

< Model Verification >

The error rate is calculated by comparing the predicted values of power generation amount according to the exemplary embodiment and the comparative embodiment with the actual power generation amount, and the nMAE value described in [Equation 4] below is used in the calculation. Here, nMAE means a normalized mean absolute value error.

[Equation 4]

$$nMAE = \frac{1}{N} \sum_{i=1}^{n} \frac{|M_i - O_i|}{O_{mean}} \times 100\%$$

(where, M: model value, O: observed value, n, N: number of data)

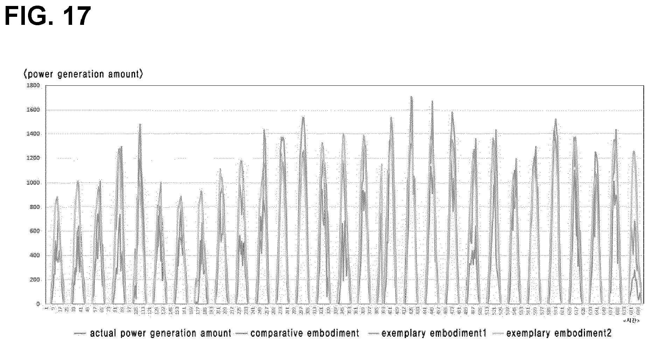

The calculated result of each error rate is shown in Table 1 below. The error rate of the exemplary embodiment 1, in which the step S13 of processing model statistics, step S14 of interpolating data, and step S15 of combining models are performed, shows a lesser value than that of the comparative embodiment 1, in which only the physical models are executed to predict the power generation amount, and the error rate of exemplary embodiment 2, in which the step S31 of tracking a position of the sun and step S33 of estimating module temperature are applied in addition to the exemplary embodiment 1, shows a lesser value than that of exemplary embodiment 1. Among these error verifications, a graph of the actual solar power generation amount and the power generation amounts of the exemplary embodiment and comparative embodiment in July 2017 is shown in FIG. 17.

[Table 1]

|  | Error Rate (nMAE) |
|---|---|
| Comparative Embodiment 1 | 17.1% |
| Exemplary Embodiment 1 | 15.7% |
| Exemplary Embodiment 2 | 14.8% |

Therefore, it can be seen that when the step S1 of forecasting weather and/or the step S3 of predicting power generation amount according to the present invention is performed, a low error rate is obtained compared to that of the power generation amount prediction by means of general weather forecasting.

**Claims**

1. A real-time solar power generation amount prediction system, the system comprising:

a solar power generator installed at a certain place and generating power by sunlight;
a monitoring server for predicting weather at the place where the solar power generator is installed and predicting a solar power generation amount of the solar power generator by using predicted weather information and solar power generator information; and
a display for displaying the weather information and the solar power generation amount predicted by the monitoring server,
wherein the monitoring server comprises:

a weather forecasting part (31) for predicting the weather at the place where the solar power generator is located; and
a power generation amount prediction part (33) for predicting the solar power generation amount at a specific time on the basis of the weather information predicted by the weather forecasting part, and
the weather forecasting part (31) comprises:

a weather observation receiving part (311) for receiving weather observation data;
a physical model execution part (312) for executing a plurality of physical models for forecasting the weather on the basis of the weather observation data received from the weather observation receiving part;
a model statistics processing part (313) for correcting values predicted by the physical models through a linear regression equation by comparing, for a certain period of time, the weather information predicted by the physical models and actual measured weather information;
a data interpolation part (314) for extracting weather observation values at the place where the solar power generator is located by interpolating the weather observation values around the place where the solar power generator is located through a spatial distribution correction technique; and

a model combination part (315) for setting a combined physical model, having the least error rate and interpolated actual measured values, by combining each of the physical models corrected by the model statistics processing part, wherein

the model statistics processing part (313) comprises:

a grid point selection module (313a) for selecting a grid point at the shortest distance from the place where the solar power generator is located;

a grouping module (313b) by preceding time for grouping weather data, by preceding time, predicted by the physical models for the selected grid point;

a correlation coefficient analysis module (313c) for analyzing a correlation coefficient between the predicted weather data and actual measured data in a specific time period; and

a regression analysis execution module (313d) for deriving the linear regression equation by using the analyzed correlation coefficient and calculating corrected model execution values,

the data interpolation part (314) comprises:

a case classification module (314a) for classifying cases according to a distance between the place where the solar power generator is located and a place at which the weather observation data is measured;

a function calculation module (314b) for defining a linear relationship regarding spatial distribution characteristics for each case;

a weight calculation module (314c) for calculating a weight for each measurement place; and

an interpolation value calculation module (314d) for calculating the weather observation values at the place where the solar power generator is located in consideration of the weight of each measurement place,

wherein the model combination part (315) comprises:

an optional execution module (315a) for selecting the physical models having a less error from the actual measured values by selectively using the plurality of physical models;

an average execution module (315b) for calculating predicted values by averaging values calculated by the plurality of physical models;

a weight execution module (315c) for calculating the predicted values by assigning the weight to any one of the plurality of physical models, or by assigning the weight for each preceding time; and

an error analysis verification module (315d) for selecting and setting prediction models having the least error as the physical models of a corresponding solar power generator by comparing the predicted values calculated by the optional execution module, the average execution module, and the weight execution module with the actual measured values.

2. The system of claim 1, wherein the power generation amount prediction part (33) comprises:

a solar position tracking part (331) for tracking a position of the sun over time;

an insolation correction part (332) for correcting an insolation predicted by the weather forecasting part according to the position of the sun and a solar tracking mode of the solar power generator;

a module temperature estimation part (333) for estimating surface temperature of a solar module by using the weather information predicted by the weather forecasting part and information on the solar power generator; and

a power generation amount calculation part (334) for calculating the solar power generation amount by using the corrected insolation and the estimated surface temperature of the solar module.

3. The system of claim 2, wherein the insolation correction part (332) comprises:

a predicted insolation receiving module (332a) for receiving insolation information predicted by the weather forecasting part;

a solar position information receiving module (332b) for receiving information of time-specific elevation angle and azimuth angle of the sun tracked by the solar position tracking part;

a solar tracking mode receiving module (332c) for receiving information on the solar tracking mode of the solar power generator; and

an insolation calculation module (332d) for calculating and correcting the predicted insolation by calculating an angle between the sun and a module of the solar power generator according to the solar tracking mode of the solar power generator and the position of the sun.

4. The system of claim 2, wherein the module temperature estimation part (333) comprises:

a wind speed information receiving module (333a) for receiving information on wind speed predicted by the weather forecasting part;

a temperature information receiving module (333b) for receiving information about temperature;

an insolation information receiving module (333c) for receiving information on the insolation calculated by the insolation correction part;

a cooling device information receiving module (333d) for receiving information on a cooling device of the solar power generator;

a module temperature information receiving module (333e) for receiving information on actual measured module surface temperature of the solar power generator;

a correlation analysis module (333f) for analyzing a correlation between the temperature, the wind speed, the insolation, performance of the cooling device, and the actual measured module surface temperature; and

a module surface temperature calculation module (333g) for predicting and calculating the module surface temperature at a specific point in time according to the analyzed correlation.

5. A solar power generation amount calculation method using the system of claim 1, the method comprising:

predicting weather, wherein the weather at a place where a solar power generator is located is predicted; and

predicting a power generation amount, wherein a solar power generation amount is predicted at a specific time on the basis of weather information predicted in the predicting of the weather, wherein the predicting of the weather comprises:

receiving a weather observation, wherein weather observation data is received;

executing each physical model, wherein each physical model for forecasting the weather is executed on the basis of the weather observation data received in the receiving of the weather observation;

processing model statistics, wherein the predicted values predicted by each physical model through a linear regression equation is corrected by comparing the weather information predicted by each physical model with the actual measured weather information, for a certain period of time;

interpolating data, wherein weather observation values at the place where the solar power generator is located is extracted by interpolating the weather observation values, at the place where the solar power generator is located, through a spatial distribution correction technique; and

combining models, wherein a plurality of physical models is executed in the executing of each physical model, and by combining the plurality of physical models, a combined physical model having the least error rate and interpolated values is set.

**Patentansprüche**

1. Echtzeitvorhersagesystem für eine Solarstromerzeugungsmenge, wobei das System Folgendes umfasst:

einen Solarstromgenerator, der an einem bestimmten Ort installiert ist und Strom aus Sonnenlicht erzeugt;

einen Überwachungsserver zum Vorhersagen eines Wetters an dem Ort, an dem der Solarstromgenerator installiert ist, und Vorhersagen einer Solarstromerzeugungsmenge des Solarstromgenerators unter Verwendung von vorhergesagten Wetterinformationen und Solarstromgeneratorinformationen und

eine Anzeige zum Anzeigen der vom Überwachungsserver vorhergesagten Wetterinformationen und Solarstromerzeugungsmenge,
wobei der Überwachungsserver Folgendes umfasst:

einen Wetterprognoseteil (31) zum Vorhersagen des Wetters an dem Ort, an dem sich der Solarstromgenerator befindet; und
einen Stromerzeugungsmengenvorhersageteil (33) zum Vorhersagen einer Solarstromerzeugungsmenge zu einer spezifischen Zeit auf Basis der vom Wetterprognoseteil vorhergesagten Wetterinformationen und
der Wetterprognoseteil (31) umfasst Folgendes:

einen Wetterbeobachtungsempfangsteil (311) zum Empfangen von Wetterbeobachtungsdaten;
einen Ausführungsteil (312) für physische Modelle zum Ausführen einer Vielzahl von physischen Modellen zum Vorhersagen des Wetters auf Basis der Wetterbeobachtungsdaten, die vom Wetterbeobachtungsempfangsteil empfangen werden;
einen Modellstatistikverarbeitungsteil (313) zum Korrigieren von Werten, die von den physischen Modellen vorhergesagt werden, über eine Gleichung für lineare Regression durch Vergleichen der von den physischen Modellen vorhergesagten Wetterinformationen und tatsächlich gemessenen Wetterinformationen für eine bestimmte Zeitperiode;
einen Dateninterpolationsteil (314) zum Extrahieren von Wetterbeobachtungswerten an dem Ort, an dem sich der Solarstromgenerator befindet, durch Interpolieren der Wetterbeobachtungswerte an dem Ort, an dem sich der Solarstromgenerator befindet, über eine räumliche Verteilungskorrekturtechnik und
einen Modellkombinationsteil (315) zum Einstellen eines kombinierten physischen Modells, das die kleinste Fehlerrate und interpolierte tatsächliche Messwerte aufweist, durch Kombinieren von jedem der physischen Modelle, die vom Modellstatistikverarbeitungsteil korrigiert werden,
wobei
der Modellstatistikverarbeitungsteil (313) Folgendes umfasst:

ein Rasterpunktauswahlmodul (313a) zum Auswählen eines Rasterpunkts im kürzesten Abstand von dem Ort, an dem sich der Solarstromgenerator befindet;
ein Gruppierungsmodul (313b) nach vorheriger Zeit zum Gruppieren von Wetterdaten nach vorheriger Zeit, die von den physischen Modellen für den ausgewählten Rasterpunkt vorhergesagt werden;
ein Korrelationskoeffizientenanalysemodul (313c) zum Analysieren eines Korrelationskoeffizienten zwischen den vorhergesagten Wetterdaten und tatsächlichen Messdaten in einer spezifischen Zeitperiode und
ein Regressionsanalyseausführungsmodul (313d) zum Ableiten der Gleichung für lineare Regression durch Verwenden des analysierten Korrelationskoeffizienten und Berechnen von korrigierten Modellausführungswerten,
der Dateninterpolationsteil (314) Folgendes umfasst:

ein Fallklassifizierungsmodul (314a) zum Klassifizieren von Fällen gemäß einem Abstand zwischen dem Ort, an dem sich der Solarstromgenerator befindet, und einem Ort, an dem die Wetterbeobachtungsdaten gemessen werden;
ein Funktionsberechnungsmodul (314b) zum Definieren einer linearen Beziehung hinsichtlich räumlicher Verteilungseigenschaften für jeden Fall;
ein Gewichtungsberechnungsmodul (314c) zum Berechnen einer Gewichtung für jeden Messeort und
ein Interpolationswertberechnungsmodul (314d) zum Berechnen der Wetterbeobachtungswerte an dem Ort, an dem sich der Solarstromgenerator befindet, unter Berücksichtigung der Gewichtung von jedem Messeort,
wobei das Modellkombinationsteil (315) Folgendes umfasst:

ein optionales Ausführungsmodul (315a) zum Auswählen der physischen Modelle mit einem kleineren Fehler im Vergleich zu den tatsächlichen Messwerten durch selektives Verwenden der Vielzahl von physischen Modellen;
ein Mittelungsausführungsmodul (315b) zum Berechnen von vorhergesagten Werten durch Mitteln von Werten, die von der Vielzahl von physischen Modellen berechnet werden;
ein Gewichtungsausführungsmodul (315c) zum Berechnen der vorhergesagten Werte durch Zuweisen der Gewichtung zu jedem der Vielzahl von physischen Modellen oder durch Zuweisen der Gewichtung für jede vorausgehende Zeit und
ein Fehleranalyseverifizierungsmodul (315d) zum Auswählen und Einstellen von Vorhersagemodellen mit dem kleinsten Fehler als den physischen Modellen eines entsprechenden Solarstromgenerators durch Vergleichen der vorhergesagten Werte, die vom optionalen Ausführungsmodul, vom Mittelungsausführungsmodul und vom Gewichtungsausführungsmodul berechnet werden, mit den tatsächlichen Messwerten.

2. System nach Anspruch 1, wobei das Stromerzeugungsmengenvorhersageteil (33) Folgendes umfasst:

einen Solarpositionsverfolgungsteil (331) zum Verfolgen einer Position der Sonne über die Zeit;
einen Sonneneinstrahlungskorrekturteil (332) zum Korrigieren einer Sonneneinstrahlung, die vom Wetterprognoseteil gemäß der Position der Sonne und einem Solarverfolgungsmodus des Solarstromgenerators vorhergesagt wird;
einen Modultemperaturschätzteil (333) zum Schätzen einer Oberflächentemperatur eines Solarmoduls unter Verwendung der vom Wetterprognoseteil vorhergesagten Wetterinformationen und Informationen über den Solarstromgenerator und
einen Stromerzeugungsmengenberechnungsteil (334) zum Berechnen der Solarstromerzeugungsmenge unter Verwendung der korrigierten Sonneneinstrahlung und der geschätzten Oberflächentemperatur des Solarmoduls.

3. System nach Anspruch 2, wobei der Sonneneinstrahlungskorrekturteil (332) Folgendes umfasst:

ein Sonneneinstrahlungsvorhersageempfangsmodul (332a) zum Empfangen von Sonneneinstrahlungsinformationen, die vom Wetterprognoseteil vorhergesagt werden;
ein Solarsositionsinformationsempfangsmodul (332b) zum Empfangen von Informationen eines zeitspezifischen Elevationswinkels und Azimutwinkels der vom Solarpositionsverfolgungsteil verfolgten Sonne;
ein Solarverfolgungsmodusempfangsmodul (332c) zum Empfangen von Informationen über den Solarverfolgungsmodus des Solarstromgenerators und
ein Sonneneinstrahlungsberechnungsmodul (332d) zum Berechnen und Korrigieren der vorhergesagten Sonneneinstrahlung durch Berechnen eines Winkels zwischen der Sonne und einem Modul des Solarstromgenerators gemäß dem Solarverfolgungsmodus des Solarstromgenerators und der Position der Sonne.

4. System nach Anspruch 2, wobei der Modultemperaturschätzteil (333) Folgendes umfasst:

ein Windgeschwindigkeitsinformationsempfangsmodul (333a) zum Empfangen von Informationen über eine vom Wetterprognoseteil vorhergesagte Windgeschwindigkeit;
ein Temperaturinformationsempfangsmodul (333b) zum Empfangen von Informationen über eine Temperatur;
ein Sonneneinstrahlungsinformationsempfangsmodul (333c) zum Empfangen von Informationen über eine vom Sonneneinstrahlungskorrekturteil berechnete Sonneneinstrahlung;
ein Kühlvorrichtungsinformationsempfangsmodul (333d) zum Empfangen von Informationen über eine Kühlvorrichtung des Solarstromgenerators;
ein Modultemperaturinformationsempfangsmodul (333e) zum Empfangen von Informationen über eine tatsächlich gemessene Moduloberflächentemperatur des Solarstromgenerators;

ein Korrelationsanalysemodul (333f) zum Analysieren einer Korrelation zwischen der Temperatur, der Windgeschwindigkeit, der Sonneneinstrahlung, einer Leistung der Kühlvorrichtung und der tatsächlich gemessenen Moduloberflächentemperatur und

ein Moduloberflächentemperaturberechnungsmodul (333g) zum Vorhersagen und Berechnen der Moduloberflächentemperatur zu einem spezifischen Zeitpunkt gemäß der analysierten Korrelation.

5. Verfahren zur Berechnung einer Solarstromerzeugungsmenge unter Verwendung des Systems nach Anspruch 1, wobei das Verfahren Folgendes umfasst:

Vorhersagen eines Wetters, wobei das Wetter an einem Ort vorhergesagt wird, an dem sich der Solarstromgenerator befindet; und
Vorhersagen einer Stromerzeugungsmenge, wobei eine Solarstromerzeugungsmenge zu einer spezifischen Zeit auf Basis der beim Vorhersagen des Wetters vorhergesagten Wetterinformationen vorhergesagt wird,
wobei das Vorhersagen des Wetters Folgendes umfasst:

Empfangen einer Wetterbeobachtung, wobei Wetterbeobachtungsdaten empfangen werden;
Ausführen von jedem physischen Modell, wobei jedes physische Modell zum Vorhersagen des Wetters auf Basis der beim Empfangen der Wetterbeobachtung empfangenen Wetterbeobachtungsdaten ausgeführt wird;
Verarbeiten einer Modellstatistik, wobei die vorhergesagten Werte, die von jedem physischen Modell über eine Gleichung für lineare Regression vorhergesagt werden, durch Vergleichen der von jedem physischen Modell vorhergesagten Wetterinformationen mit den tatsächlich gemessenen Wetterinformationen für eine bestimmte Zeitperiode korrigiert wird;
Interpolieren von Daten, wobei Wetterbeobachtungswerte an dem Ort, an dem sich der Solarstromgenerator befindet, durch Interpolieren der Wetterbeobachtungswerte an dem Ort, an dem sich der Solarstromgenerator befindet, über eine räumliche Verteilungskorrekturtechnik extrahiert wird; und
Kombinieren von Modellen, wobei beim Ausführen von jedem physischen Modell eine Vielzahl von physischen Modellen ausgeführt wird, und durch Kombinieren der Vielzahl von physischen Modellen ein kombiniertes physisches Modell, das die kleinste Fehlerrate und interpolierte Werte aufweist, eingestellt wird.

**Revendications**

1. Système de prédiction de quantité de génération d'énergie solaire en temps réel, le système comprenant :

un générateur d'énergie solaire installé à un certain endroit et générant de l'énergie par la lumière du soleil ;
un serveur de surveillance pour prédire une météo à l'endroit où le générateur d'énergie solaire est installé et prédire une quantité de génération d'énergie solaire du générateur d'énergie solaire par utilisation d'informations météorologiques prédites et d'informations de générateur d'énergie solaire ; et
un affichage pour afficher les informations météorologiques et la quantité de génération d'énergie solaire prédite par le serveur de surveillance,
dans lequel le serveur de surveillance comprend :

une partie de prévision météorologique (31) pour prédire la météo à l'endroit où le générateur d'énergie solaire est localisé ; et
une partie de prédiction de quantité de génération d'énergie (33) pour prédire la quantité de génération d'énergie solaire à un temps spécifique en fonction des informations météorologiques prédites par la partie de prévision météorologique, et
la partie de prévision météorologique (31) comprend :

une partie de réception d'observation météorologique (311) pour recevoir des données d'observation météorologique ;
une partie d'exécution de modèle physique (312) pour exécuter une pluralité de modèles physiques pour prévoir la météo en fonction des données d'observation météorologique reçues à partir de la partie de réception d'observation météorologique ;
une partie de traitement de statistiques de modèle (313) pour corriger des valeurs prédites par les modèles physiques à travers une équation de régression linéaire par comparaison, pendant une certaine période de temps, des informations météorologiques prédites par les modèles physiques et des informations météorologiques réelles mesurées ;

une partie d'interpolation de données (314) pour extraire des valeurs d'observation météorologique à l'endroit où le générateur d'énergie solaire est localisé par interpolation des valeurs d'observation météorologique autour de l'endroit où le générateur d'énergie solaire est localisé à travers une technique de correction de distribution spatiale ; et

une partie de combinaison de modèles (315) pour définir un modèle physique combiné, ayant le taux d'erreur le moindre et des valeurs réelles mesurées interpolées, par combinaison de chacun des modèles physiques corrigés par la partie de traitement de statistiques de modèle,

dans lequel

la partie de traitement de statistiques de modèle (313) comprend :

un module de sélection de point de grille (313a) pour sélectionner un point de grille à la distance la plus courte à partir de l'endroit où le générateur d'énergie solaire est localisé ;

un module de groupement (313b) par un temps précédent pour grouper des données météorologiques, par un temps précédent, prédites par les modèles physiques pour le point de grille sélectionné ;

un module d'analyse de coefficient de corrélation (313c) pour analyser un coefficient de corrélation entre les données météorologiques prédites et les données réelles mesurées dans une période de temps spécifique ; et

un module d'exécution d'analyse de régression (313d) pour dériver l'équation de régression linéaire par utilisation du coefficient de corrélation analysé et calcul de valeurs d'exécution de modèle corrigées,

la partie d'interpolation de données (314) comprend :

un module de classification de cas (314a) pour classer des cas conformément à une distance entre l'endroit où le générateur d'énergie solaire est localisé et un endroit auquel les données d'observations météorologiques sont mesurées ;

un module de calcul de fonction (314b) pour définir une relation linéaire concernant des caractéristiques de distribution spatiale pour chaque cas ;

un module de calcul de poids (314c) pour calculer un poids pour chaque endroit de mesure ; et

un module de calcul de valeur d'interpolation (314d) pour calculer les valeurs d'observation météorologique à l'endroit où le générateur d'énergie solaire est localisé compte tenu du poids de chaque endroit de mesure,

dans lequel la partie de combinaison de modèles (315) comprend :

un module d'exécution optionnel (315a) pour sélectionner les modèles physiques ayant une erreur moindre à partir des valeurs réelles mesurées par utilisation sélective de la pluralité de modèles physiques ;

un module d'exécution de moyenne (315b) pour calculer des valeurs prédites par réalisation d'une moyenne de valeurs calculées par la pluralité de modèles physiques ;

un module d'exécution de poids (315c) pour calculer les valeurs prédites par assignation du poids à l'un quelconque de la pluralité de modèles physiques, ou par assignation du poids pour chaque temps précédent ; et

un module de vérification d'analyse d'erreur (315d) pour sélectionner et définir des modèles de prédiction ayant l'erreur la moindre comme les modèles physiques d'un générateur d'énergie solaire correspondant par comparaison des valeurs prédites calculées par le module d'exécution optionnel, le module d'exécution de moyenne, et le module d'exécution de poids avec les valeurs réelles mesurées.

2. Système selon la revendication 1, dans lequel la partie de prédiction de quantité de génération d'énergie (33) comprend :

une partie de suivi de position solaire (331) pour suivre une position du soleil au fil du temps ;
une partie de correction d'insolation (332) pour corriger une insolation prédite par la partie de prévision météorologique conformément à la position du soleil et à un mode de suivi solaire du générateur d'énergie solaire ;
une partie d'estimation de température de module (333) pour estimer une température de surface d'un module solaire par utilisation des informations météorologiques prédites par la partie de prévision météorologique et d'informations sur le générateur d'énergie solaire ; et
une partie de calcul de quantité de génération d'énergie (334) pour calculer la quantité de génération d'énergie solaire par utilisation de l'insolation corrigée et de la température de surface estimée du module solaire.

3. Système selon la revendication 2, dans lequel la partie de correction d'insolation (332) comprend :

un module de réception d'insolation prédite (332a) pour recevoir des informations d'insolation prédites par la partie de prévision météorologique ;
un module de réception d'informations de position solaire (332b) pour recevoir des informations d'angle d'élévation et d'angle d'azimut spécifiques au temps du soleil suivi par la partie de suivi de position solaire ;
un module de réception de mode de suivi solaire (332c) pour recevoir des informations sur le mode de suivi solaire du générateur d'énergie solaire ; et
un module de calcul d'insolation (332d) pour calculer et corriger l'insolation prédite par calcul d'un angle entre le soleil et un module du générateur d'énergie solaire conformément au mode de suivi solaire du générateur d'énergie solaire et à la position du soleil.

4. Système selon la revendication 2, dans lequel la partie d'estimation de température de module (333) comprend :

un module de réception d'informations de vitesse de vent (333a) pour recevoir des informations sur une vitesse de vent prédite par la partie de prévision météorologique ;
un module de réception d'informations de température (333b) pour recevoir des informations à propos d'une température ;
un module de réception d'informations d'insolation (333c) pour recevoir des informations sur l'insolation calculée par la partie de correction d'insolation ;
un module de réception d'informations de dispositif de refroidissement (333d) pour recevoir des informations sur un dispositif de refroidissement du générateur d'énergie solaire ;
un module de réception d'informations de température de module (333e) pour recevoir des informations sur une température de surface de module réelle mesurée du générateur d'énergie solaire ;
un module d'analyse de corrélation (333f) pour analyser une corrélation entre la température, la vitesse de vent, l'insolation, des performances du dispositif de refroidissement, et la température de surface de module réelle mesurée ; et
un module de calcul de température de surface de module (333g) pour prédire et calculer la température de surface de module à un point spécifique dans le temps conformément à la corrélation analysée.

5. Procédé de calcul de quantité de génération d'énergie solaire utilisant le système selon la revendication 1, le procédé comprenant :

la prédiction de météo, dans laquelle la météo à un endroit où un générateur d'énergie solaire est localisé est prédite ; et
la prédiction d'une quantité de génération d'énergie, dans laquelle une quantité de génération d'énergie solaire est prédite à un temps spécifique en fonction d'informations météorologiques prédites dans la prédiction de la météo, dans laquelle la prédiction de la météo comprend :

la réception d'une observation météorologique, dans laquelle des données d'observation météorologique sont reçues ;
l'exécution de chaque modèle physique, dans laquelle chaque modèle physique pour prévoir la météo est exécuté en fonction des données d'observation météorologique reçues dans la réception de l'observation météorologique ;

le traitement de statistiques de modèle, dans lequel les valeurs prédites prédites par chaque modèle physique à travers une équation de régression linéaire est corrigée par comparaison des informations météorologiques prédites par chaque modèle physique avec les informations météorologiques réelles mesurées, pendant une certaine période de temps ;

l'interpolation de données, dans laquelle des valeurs d'observation météorologique à l'endroit où le générateur d'énergie solaire est localisé est extraite par interpolation des valeurs d'observation météorologique, à l'endroit où le générateur d'énergie solaire est localisé, à travers une technique de correction de distribution spatiale ; et

la combinaison de modèles, dans laquelle une pluralité de modèles physiques est exécutée dans l'exécution de chaque modèle physique, et par combinaison de la pluralité de modèles physiques, un modèle physique combiné ayant le taux d'erreur le moindre et des valeurs interpolées est défini.

FIG. 1

FIG. 2

## FIG. 3

*31*

weather forecasting part

weather observation receiving part — *311*

physical model execution part — *312*

model statistics processing part — *313*

data interpolation part — *314*

model combination part — *315*

statistical analysis part — *316*

## FIG. 4

*312*

physical model execution part

initial field receiving module — *312a*

physical model execution module — *312b*

model optimization module — *312c*

FIG. 5

*313*

| model statistics processing part |
|---|

| grid point selection module | *313a* |
| grouping module by preceding time | *313b* |
| correlation coefficient analysis module | *313c* |
| regression analysis execution module | *313d* |

## FIG. 6

(a)

(b)

**FIG. 7**

*314*

| data interpolation part |

| case classification module | ~ *314a*
| function calculation module | ~ *314b*
| weight calculation module | ~ *314c*
| interpolation value calculation module | ~ *314d*

**FIG. 8**

# FIG. 9

*315*

| model combination part |
|:---:|
| optional execution module |
| average execution module |
| weight execution module |
| error analysis verification module |

*315a*

*315b*

*315c*

*315d*

# FIG. 10

*315a*

multiple models

WRF

LDAPS

optional execution module

average execution module

weight execution module

error analysis verification module

*315b*

*315c*

*315d*

## FIG. 11

*316*

statistical analysis part

statistical analysis
execution module — *316a*

error verification module — *316b*

## FIG. 12

*33*

power generation amount
prediction part

solar position tracking part — *331*

insolation correction part — *332*

module temperature
estimation part — *333*

power generation amount
calculation part — *334*

## FIG. 13

*332*

| insolation correction part |
| --- |
| predicted insolation receiving module |
| solar position information receiving module |
| solar tracking mode receiving module |
| insolation calculation module |

*332a*
*332b*
*332c*
*332d*

## FIG. 14

*333*

| module temperature estimation part |
| --- |
| wind speed information receiving module |
| temperature information receiving module |
| insolation information receiving module |
| cooling device information receiving module |
| module temperature information receiving module |
| correlation analysis module |
| module surface temperature calculation module |

*333a*
*333b*
*333c*
*333d*
*333e*
*333f*
*333g*

**FIG. 15**

*334*

power generation amount calculation part

rated output receiving module — *334a*

corrected insolation receiving module — *334b*

module temperature receiving module — *334c*

output temperature coefficient receiving module — *334d*

loss coefficient calculation module — *334e*

power generation amount calculation module — *334f*

EP 3 829 055 B1

## FIG. 16

*S12*  *S11*

executing each physical model → processing model statistics *S13*

receiving weather observation → interpolating data *S14*

combining models *S15*

analyzing statistics *S16*

**S1**

**S3**

*S31*

tracking position of sun → correcting insolation *S32*

tracking mode information

temperature information

wind speed information

cooling device information → estimating module temperature

*S33*

maximum output information → calculating power generation amount ← loss factorcalculation

output temperature coefficient information

*S34*

30

# FIG. 17

⟨power generation amount⟩

—— actual power generation amount —— comparative embodiment —— exemplary embodiment1 —— exemplary embodiment2

**EP 3 829 055 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018196896 A
- KR 101020639